# EUROPEAN PATENT APPLICATION

(11) **EP 3 913 760 A1**
(43) Date of publication of application: **24.11.2021**
(21) Application number: 21174153.3
(22) Date of filing: 17.05.2021
(51) Int. Cl.: H02J 3/00, H02J 3/24, H02J 3/38

(54) **ELECTRICAL GRID CONTROL DEVICE AND POWER GENERATION SYSTEM**

(30) Priority: 19.05.2020 JP 2020087222
(71) Applicant: Hitachi, Ltd., Tokyo 100-8280 (JP)
(72) Inventor: IMABAYASHI, Masataka, Tokyo, 100-8280 (JP); YOSHIHARA, Tohru, Tokyo, 100-8280 (JP); LEE, Chia Tse, Tokyo, 100-8280 (JP); WADA, Norihisa, Tokyo, 100-8280 (JP)
(74) Representative: MERH-IP Matias Erny Reichl Hoffmann Patentanwälte PartG mbB

(57) **Abstract**

An electrical grid control device includes a data acquisition unit (220) that acquires measurement data including a voltage value and a current value of each unit in an electrical grid in which a power conversion device is connected, and a control method selection unit that selects a control method when active power and reactive power output to the electrical grid by the power conversion device are controlled based on the acquired measurement data.

## Description

### BACKGROUND OF THE INVENTION

### 1. Field of the Invention

The present invention relates to an electrical grid control device and a power generation system.

### 2. Description of the Related Art

In order to maintain stability of an electrical grid, electrical grid monitoring devices decide a control method of a circuit breaker and a thermal power generator while monitoring a voltage and a frequency in the electrical grid. One of the electrical grid monitoring devices is known as a remedial action scheme (RAS) (NERC; "Remedial Action Scheme" Definition Development, June 2014, [Searched on April 24, 2020], Internet <https://www.nerc.com/pa/Stand/Prjct201005_2SpclPrtctnSstmP hs2/FAQ_RAS_Definition_0604_final.pdf>). The RAS is a method for calculating analysis of a plurality of assumed system accidents every predetermined time and deciding a control method of a synchronous generator or a circuit breaker of a load immediately after accident occurrence. In Spain, the electrical grid monitoring device called a "central power supply command station for renewable energy" is established, and there is a movement to control renewable energy power generation as well in addition to the circuit breaker and the thermal power generator. On the other hand, since an output of the renewable energy power generation fluctuates depending on the weather, the influence on a stable operation of the electrical grid is large.

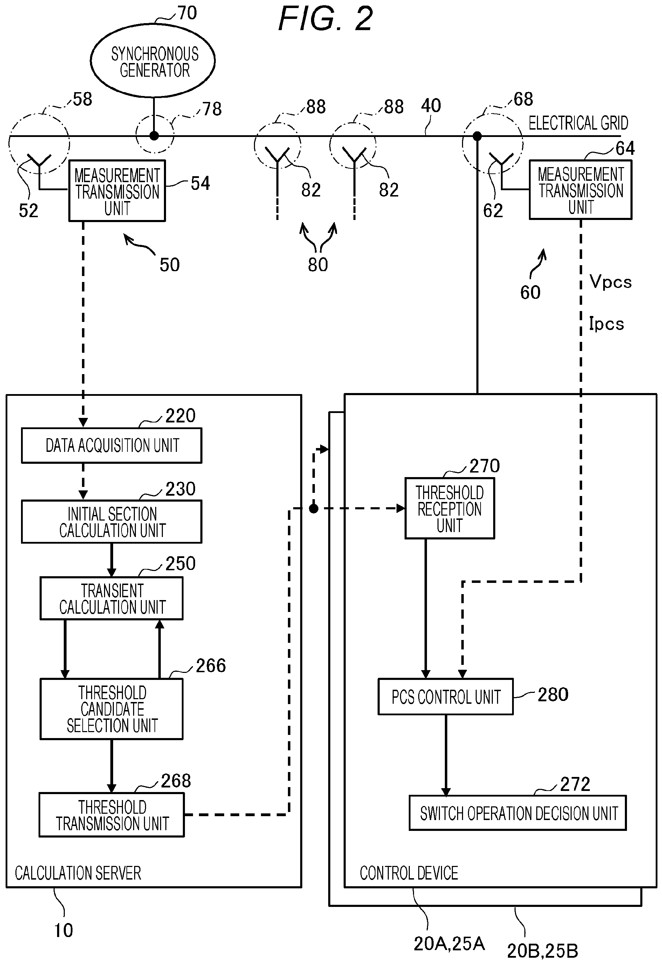

Under such circumstances, in recent years, there has been a demand for contribution to a system stable operation of the renewable energy power generation. For example, paragraph 0019 of JP 2013-48504 A describes that "Fig. 2 is a waveform diagram illustrating an example of a fluctuation signal and a stabilization signal. For example, when the fluctuation signal is an instantaneous frequency, the amount of change from a steady value of the instantaneous frequency is obtained. As illustrated in Fig. 2, a vibration waveform with the stationary value as a center is obtained. When the stationary value of the frequency is zero, the vibration waveform with zero as a center is obtained. The vibration of the frequency indicates the vibration of power of the electrical grid. Since the instantaneous frequency increases when an instantaneous power is excessive, output power P of a photovoltaic facility is reduced. Accordingly, the vibration of the power can be suppressed". Japan Science and Technology Agency, Analysis on Transient Stabilities in Decarbonizing Power Systems with Large-scale Integration of Renewable Power Sources, March 2017, [Searched on April 24, 2020], Internet <https://www.jst.go.jp/lcs/pdf/fy2016-pp-16.pdf> and WECC; WECC Type 3 Wind Turbine Generator Model-Phase II: January 23, 2014 will be described later.

### SUMMARY OF THE INVENTION

However, when an accident occurs in the electrical grid, the voltage and the frequency of the electrical grid fluctuate in a complicated manner. According to the technique described in JP 2013-48504 A, the frequency vibration can be suppressed, but the electrical grid may not be appropriately stabilized only by this technique.

The present invention has been made in view of the above circumstances, and an object of the present invention is to provide an electrical grid control device and a power generation system capable of appropriately stabilizing an electrical grid.

In order to solve the above problems, there is provided an electrical grid control device of the present invention includes a data acquisition unit that acquires measurement data including a voltage value and a current value of each unit in an electrical grid to which a power conversion device is connected, and a control method selection unit that selects a control method when active power and reactive power output to the electrical grid by the power conversion device are controlled based on the acquired measurement data.

According to the present invention, the electrical grid can be appropriately stabilized.

### BRIEF DESCRIPTION OF THE DRAWINGS

Fig. 1 is a block diagram of a renewable energy power generation system according to a preferred first embodiment;
Fig. 2 is a functional block diagram realized by a calculation server and a control device of a PC;
Fig. 3 is a block diagram illustrating an example of a detailed configuration of an initial section calculation unit;
Fig. 4 is a block diagram illustrating examples of calculation models and functional blocks of a transient calculation unit;
Fig. 5 is a block diagram illustrating an example of a PCS behavior calculation model;
Fig. 6 is a flowchart illustrating an example of a calculation processing routine;
Fig. 7 is a flowchart illustrating an example of a threshold selection routine;
Fig. 8 is a block diagram illustrating an example of a control block of a PCS control unit;
Fig. 9 is a functional block diagram realized by a calculation server and a control device of a PC in a preferred second embodiment;
Fig. 10 is a flowchart illustrating an example of a reactive power command value selection routine according to the second embodiment;
Fig. 11 is a functional block diagram realized by a calculation server and a control device of a PC in a preferred third embodiment; and
Fig. 12 is a diagram illustrating an example of types of teaching data used for machine learning in the third embodiment.

### DESCRIPTION OF THE PREFERRED EMBODIMENTS

### Outline of embodiments

Hereinafter, first, the stability of an electrical grid when there is an accident in the electrical grid will be described, and the influence of the accident on the stability when renewable energy power generation is interconnected to the system will be described. Thereafter, a control method of the renewable energy power generation contributing to the electrical grid will be described.

A state in which the electrical grid is stable refers to a state in which a voltage and a frequency of the system are maintained within thresholds in both normal and accident conditions.

When the accident occurs in the electrical grid, the voltage and the frequency greatly fluctuate. Thereafter, the fluctuations in the voltage and frequency may be diverged to units of the electrical grid depending on a timing of accident removal by a protective relay system or the like.

The fluctuations in the voltage and frequency after the accident removal change depending on an output state of the renewable energy power generation. For example, Japan Science and Technology Agency, Analysis on Transient Stabilities in Decarbonizing Power Systems with Large-scale Integration of Renewable Power Sources, March 2017, [Searched on April 24, 2020], Internet <https://www.jst.go.jp/lcs/pdf/fy2016-pp-16.pdf> indicates that the output state of the renewable energy power generation influences the frequency of the electrical grid. In other words, it is possible to contribute to a stable operation of the electrical grid by appropriately controlling the output state of the renewable energy power generation. A method for contributing to the stable operation of the system after the accident removal by the renewable energy power generation is classified according to four control methods C1 to C4 according to the voltage and frequency in the accident condition.

### •Control method C1 (first control method): when system voltage drops and frequency increases

In this case, there is a possibility that a step-out phenomenon occurs in a synchronous generator in the electrical grid. Thus, it is preferable that an output of the synchronous generator is increased by suppressing active power of the renewable energy power generation and outputting capacitive reactive power (lead reactive power), step-out is suppressed, and the system voltage is simultaneously maintained. More specifically, the renewable energy power generation may output the capacitive reactive power, and a power factor may be less than a predetermined value thpf1 (not shown).

### •Control method C2 (second control method): when the system voltage decreases and the frequency decreases

In this case, there is a possibility that the generator in the electrical grid falls off. Therefore, it is preferable that the system voltage is maintained while maintaining the supply and demand balance in the electrical grid by increasing the active power of the renewable energy power generation and outputting the capacitive reactive power. More specifically, the renewable energy power generation may output the capacitive reactive power, and the power factor may be set to be equal to or greater than the predetermined value thpf1.

### •Control method C3 (third control method): when the system voltage increases and the frequency increases

In this case, there is a possibility that a load in the electrical grid falls off. Therefore, it is preferable that an apparent load look large by suppressing the active power of the renewable energy power generation and outputting an inductive reactive power (delay reactive power), and thus, the supply and demand balance is maintained. More specifically, the renewable energy power generation may output the inductive reactive power, and thus, the power factor may be set to be less than a predetermined value thpf2 (not shown).

### •Control method C4 (fourth control method): When the system voltage increases and the frequency decreases

In this case, there is a possibility that the generator in the electrical grid falls off. Therefore, it is preferable that an insufficient active power is increased by accelerating output recovery of the renewable energy power generation, a voltage of the electrical grid is lowered by outputting the inductive reactive power, and the supply and demand balance is maintained by making the apparent load look small. More specifically, the renewable energy power generation may output the inductive reactive power, and the power factor may be set to be equal to or greater than the predetermined value thpf2.

In an actual electrical grid, a control method contributing to the system stabilization changes depending on a synchronous generator, a renewable energy power generation power source, a position of an accident point, the magnitude of demand, and the like. Therefore, the above-described RAS or the like that monitors the electrical grid may calculate a voltage threshold and a frequency threshold serving as triggers for switching between the control methods by calculation in advance and may distribute the calculated values to each renewable energy power generation. Each renewable energy power generation power source can suppress the fluctuation in the voltage and the frequency in the accident condition of the electrical grid by changing the control methods C1 to C4 in the accident condition based on the distributed voltage threshold and frequency threshold.

### First embodiment

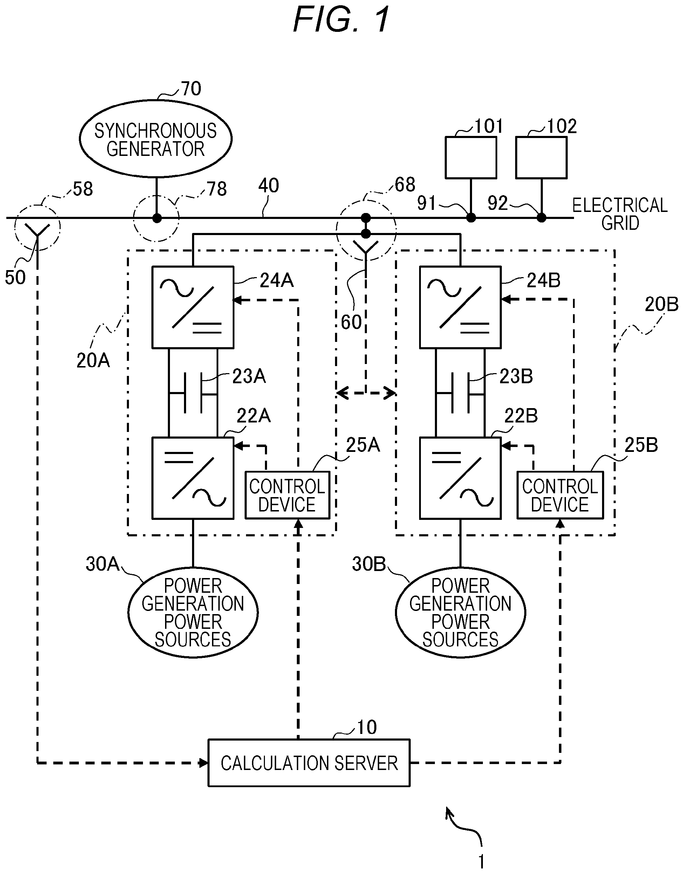

Fig. 1 is a block diagram of a renewable energy power generation system 1 (power generation system) according to a preferred first embodiment.

In Fig. 1, the renewable energy power generation system 1 includes a calculation server 10 (electrical grid control device), two power conditioning systems (PCSs; power conversion devices) 20A and 20B, two power generation power sources 30A and 30B, and measurement units 50 and 60. The PCSs 20A and 20B are connected to a three-phase electrical grid 40. A synchronous generator 70 is connected to the electrical grid 40 at a cooperation point 78, and load facilities 101 and 102 are connected to the electrical grid at demand points 91 and 92, respectively.

The power generation power sources 30A and 30B are, for example, renewable energy power generation power sources such as wind power generation. The PCSs 20A and 20B convert A frequency of AN AC power output from the power generation power sources 30A and 30B into a system frequency of the electrical grid 40, and output the system frequency to the electrical grid 40. Thus, the PCSs 20A and 20B include AC/DC converters 22A and 22B, storage batteries 23A and 23B, DC/AC converters 24A and 24B, and control devices 25A and 25B, respectively. In the illustrated example, two PCSs 20A and 20B and two power generation power sources 30A and 30B are provided, but three or more PCSs and power generation power sources may be provided, or one each may be provided.

The measurement units 50 and 60 output, as measurement data, instantaneous values of a voltage and a current of the electrical grid 40 at measurement points 58 and 68, respectively, at predetermined sampling cycles. The calculation server 10 calculates a voltage threshold and a frequency threshold with which the above-described control methods C1 to C4 are switched based on the measurement data supplied from the measurement units 50 and 60 and the like. The control devices 25A and 25B decide the control methods C1 to C4 based on the voltage threshold and the frequency threshold received from the calculation server 10, and generate an active power command value and a reactive power command value based on the decided control method. The DC/AC converters 24A and 24B output active power and reactive power corresponding to these command values to the electrical grid 40.

The calculation server 10 and the control devices 25A and 25B include hardware as a general computer, such as a central processing unit (CPU), a random access memory (RAM), a read only memory (ROM), and a solid state drive (SSD), and the SSD stores an operating system (OS), a control program, various kinds of data, and the like. The OS and the control program are developed in the RAM and is executed by the CPU.

Fig. 2 is a functional block diagram illustrating functions and the like realized by the calculation server 10 and the control devices 25A and 25B of the PCSs 20A and 20B.

In this figure, the insides of the calculation server 10 and the control device 25A illustrate functions realized by these control program and the like. Although the inside of the control device 25B is not illustrated, the control device 25B also has functions similar to those of the control device 25A.

The measurement unit 50 includes a sensor 52 and a measurement transmission unit 54. The sensor 52 measures instantaneous values of the voltage, the current, and the like of the electrical grid 40. The measurement transmission unit 54 transmits, as measurement data, the measurement result of the sensor 52 to the calculation server 10 for each predetermined sampling period.

The measurement unit 60 also includes a sensor 62 and a measurement transmission unit 64 which have similar functions. Here, since instantaneous values of the voltage, the current, and the like output from the measurement unit 60 are values at the measurement point 68 (interconnection point) at which the PCSs 20A and 20B (see Fig. 1) is interconnected with the electrical grid 40, these values are particularly referred to as an interconnection point voltage Vpcs and an interconnection point current Ipcs. A measurement unit 80 including sensors 82 at each of a plurality of measurement points 88 is provided at the electrical grid 40. The measurement result in the measurement unit 80 is also supplied to the calculation server 10.

The calculation server 10 includes a data acquisition unit 220, an initial section calculation unit 230, a threshold candidate selection unit 266 (candidate selection unit), a transient calculation unit 250, and a threshold transmission unit 268 (control method selection unit or threshold generation unit). The control device 25A includes a threshold reception unit 270, a switch operation decision unit 272, and a PCS control unit 280.

The data acquisition unit 220 acquires measurement data such as instantaneous voltage values and instantaneous current values at the corresponding measurement points 58 and 68, and 88 from the measurement units 50, 60, and 80. The initial section calculation unit 230 calculates a voltage and a current in each unit in the electrical grid 40 at the time of calculation. The calculation method in the initial section calculation unit 230 is, for example, effective value tidal flow calculation.

The threshold candidate selection unit 266 stores a plurality of combinations of candidates for the voltage threshold and the frequency threshold to be transmitted to the PCSs 20A and 20B. One combination is selected from among the plurality of combinations. The transient calculation unit 250 calculates changes in the voltage and the frequency of the electrical grid 40 before the system accident removal by using the combination of the threshold candidates selected by the threshold candidate selection unit 266 and the calculated values of the voltage and the current calculated by the initial section calculation unit 230.

The threshold candidate selection unit 266 sequentially selects the combinations of the threshold candidates that can be applied after the system accident removal. Accordingly, whenever the combination of the threshold candidates is selected, the transient calculation unit 250 simulates (calculates) the changes in the voltage and the frequency of the electrical grid 40 after the system accident removal when the threshold candidates are adopted as the voltage threshold and the frequency threshold.

Among the plurality of threshold candidates, the threshold candidates with which it is determined that the fluctuation of the voltage and the frequency of the electrical grid 40 becomes sufficiently small are adopted as the voltage threshold and the frequency threshold to be set to the PCSs 20A and 20B. The adopted voltage threshold and frequency threshold are transmitted from the threshold transmission unit 268 to the threshold reception unit 270 of each of the PCSs 20A and 20B. The voltage threshold and the frequency threshold received by the threshold reception unit 270 in each PCS are supplied to each PCS control unit 280.

The PCS control unit 280 decides a control method to be adopted among the above-described control methods C1 to C4 based on the voltage threshold, the frequency threshold, the interconnection point voltage Vpcs, and the interconnection point current Ipcs. The PCS control unit 280 decides the active power command value and the reactive power command value of the PCSs 20A and 20B based on the decided control method, and further generates the voltage command value based on these power command values. The switch operation decision unit 272 decides switching methods of the corresponding DC/AC converters 24A and 24B (see Fig. 1) based on the voltage command value. As the switching method, for example, a pulse width modulation (PWM) modulation method can be adopted.

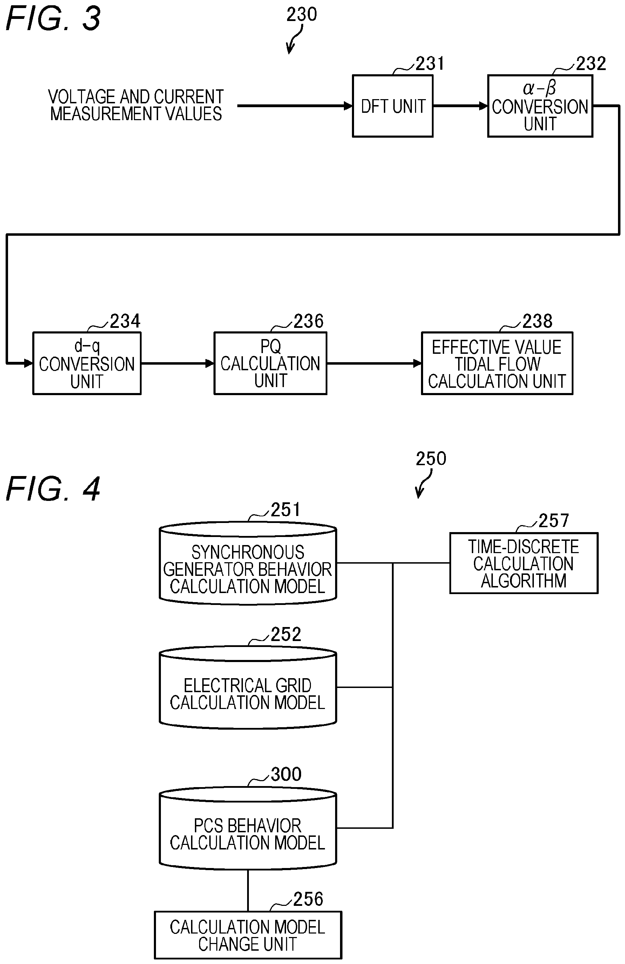

Fig. 3 is a block diagram illustrating an example of a detailed configuration of the initial section calculation unit 230.

In Fig. 3, the initial section calculation unit 230 includes a DFT unit 231, an α-β conversion unit 232, a d-q conversion unit 234, a PQ calculation unit 236, and an effective value tidal flow calculation unit 238. The DFT unit 231 performs discrete Fourier transform (DFT) on the measurement values of the three-phase voltage and current at the measurement points 58, 68, and 88 (see Fig. 2) of the electrical grid 40 (see Fig. 2), and separates the measurement values into amplitude information and phase information.

The α-β conversion unit 232 converts the measurement values of the three-phase voltage and current into information on a two-phase fixed coordinate system of a α phase and a β phase based on the DFT result. The d-q conversion unit 234 converts the information on the two-phase fixed coordinate system into information on a rotating coordinate system with a predetermined reference voltage as a reference, and acquires information on effective values. The reference voltage may be decided in advance by an operator of the present system. When the measurement values of all the voltages and currents at the measurement points 58, 68, and 88 are converted into the effective values, the PQ calculation unit 236 calculates tidal flow amounts of the active power and the reactive power at each measurement point. The effective value tidal flow calculation unit 238 calculates a flow of the power of the entire system based on the active power and the reactive power at each measurement point.

Fig. 4 is a block diagram illustrating examples of calculation models and functional blocks of the transient calculation unit 250.

In Fig. 4, the transient calculation unit 250 includes, as models, a synchronous generator behavior calculation model 251, an electrical grid model 252, and a PCS behavior calculation model 300. The transient calculation unit 250 includes, as functions, a calculation model change unit 256 and a time-discrete calculation algorithm 257. The calculation model change unit 256 changes the PCS behavior calculation model by an external command.

The transient calculation unit 250 calculate behaviors of the synchronous generator 70, the electrical grid 40, and the PCSs 20A and 20B when the accident occurs in the electrical grid 40 by using the time-discrete calculation algorithm 257, the synchronous generator behavior calculation model 251, the electrical grid model 252, and the PCS behavior calculation model 300. The synchronous generator behavior calculation model 251 is a model used in the time-discrete calculation algorithm 257, and for example, a Park model can be adopted. The electrical grid model 252 is an effective value calculation model used in the time-discrete calculation algorithm 257, and is, for example, an impedance map of a target system. The PCS behavior calculation model 300 is an effective value calculation model used in the time-discrete calculation algorithm 257, and is, for example, a model of only a current control portion of the PCS. The calculation model change unit 256 changes the PCS behavior calculation model 300 in response to a command from the threshold candidate selection unit 266.

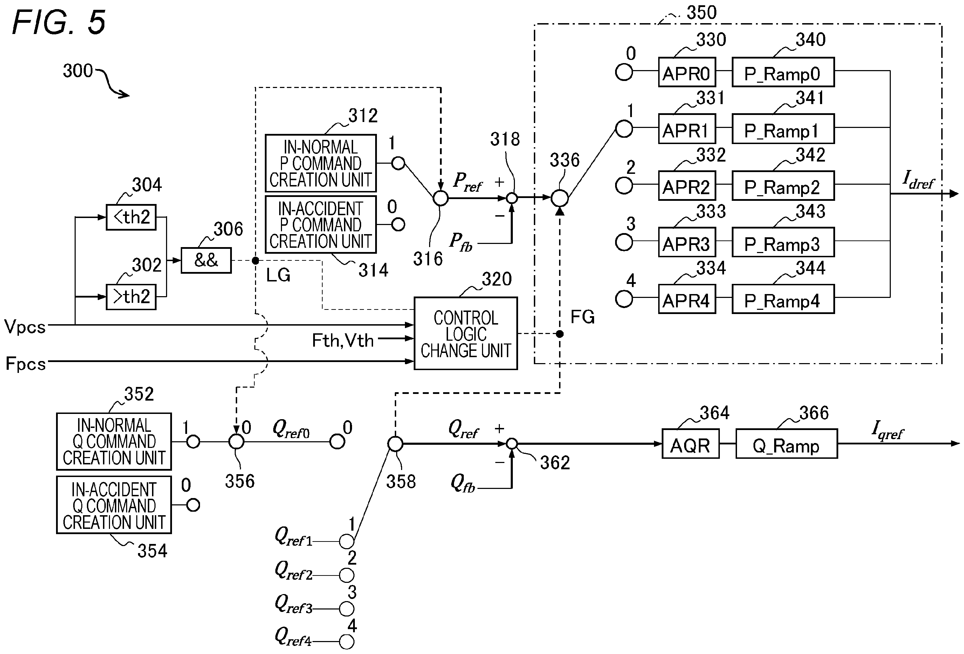

Fig. 5 is a block diagram illustrating an example of the PCS behavior calculation model 300.

This model reproduces and simulates a part of the control blocks of the PCS control unit 280 of the PCSs 20A and 20B, and is an ideal current source model assuming that a current output command value of the PCS is output to the electrical grid 40 with no change. A comparator 302 outputs "1" when the interconnection point voltage Vpcs (see Fig. 2) is larger than a threshold th1 which is an operation lower limit value of the system voltage, and outputs "0" when the interconnection point voltage Vpcs is smaller than the threshold th1. A comparator 304 outputs "1" when the interconnection point voltage Vpcs is smaller than a threshold th2 which is an operation upper limit value of the system voltage, and outputs "0" when the interconnection point voltage Vpcs is larger than the threshold th2. A logical product determiner 306 outputs a logic signal LG which becomes "1" when both the comparators 302 and 304 are "1" and becomes "0" in other cases. Accordingly, the logic signal LG becomes "1" when the interconnection point voltage Vpcs falls within an operation range of the system voltage, and becomes "0" when the interconnection point voltage Vpcs falls out of the operation range.

An in-normal P command creation unit 312 outputs an active power command value of the PCS in the normal condition. An in-accident P command creation unit 314 outputs an active power command value of the PCS in the accident condition. A switch 316 selects the former when the logic signal LG is "1", selects the latter when the logic signal LG is "0", and outputs the selection result as an active power command value P_{ref}. An in-normal Q command creation unit 352 outputs a reactive power command value of the PCS in the normal condition, and an in-accident Q command creation unit 354 outputs a reactive power command value of the PCS in the accident condition. A switch 356 selects the former when the logic signal LG is "1", selects the latter when the logic signal LG is "0", and outputs the selection result as a reactive power command value Q_{ref0}.

The logical configurations of the in-normal P command creation unit 312, the in-accident P command creation unit 314, the in-normal Q command creation unit 352, and the in-accident Q command creation unit 354 differ depending on the configuration of the PCS, but the configurations described in WECC; WECC Type 3 Wind Turbine Generator Model-Phase II: January 23, 2014 can be applied, for example. A subtractor 318 outputs a difference value between the active power command value P_{ref} and an actual active power output value P_{fb} (active power) in order to perform feedback control. A gain and ramp rate control unit 350 applies a gain to the difference value (P_{ref} - P_{fb}), limits the ramp plate, and outputs the result as a d-axis current command value I_{dref}. Accordingly, the active power output value P_{fb} is feedback-controlled such that the difference value (P_{ref} - P_{fb}) approaches zero.

A control logic change unit 320 (control method selection unit or control method change unit) decides a flag FG based on the interconnection point voltage Vpcs, an interconnection point frequency Fpcs, a voltage threshold Vth, and a frequency threshold Fth. A value of the flag FG is any integer from "0" to "4". The voltage threshold Vth and the frequency threshold Fth are threshold candidates belonging to the combination selected by the threshold candidate selection unit 266 (see Fig. 2).

A gain and ramp rate control unit 350 includes a switch unit 336, five gain application units 330 to 334, and five ramp limiters 340 to 344. The gain application units 330 to 334 correspond to the values "0" to "4" of the flag FG, and apply gains APR0 to APR4 to the difference values when the difference value (P_{ref} - P_{fb}) are input.

The ramp limiters 340 to 344 also correspond to the values "0" to "4" of the flag FG, are connected in series to the corresponding gain application units 330 to 334, and limit ramp rates of the input signal to limit values P_Ramp0 to P_Ramp4 (ramp limit values) or less. The switch unit 336 selects a corresponding circuit of these five series circuits based on the values "0" to "4" of the flag FG output from the control logic change unit 320.

A switch unit 358 selects any one of reactive power command values Q_{ref0} to Q_{ref4} (parameters) based on the values "0" to "4" of the flag FG, and outputs the selected command value as the reactive power command value Q_{ref}. A subtractor 362 outputs a difference value between the reactive power command value Q_{ref} and an actual reactive power output value Q_{fb} (reactive power) in order to perform feedback control. A gain application unit 364 applies a gain AQR to the difference value when the difference value (Q_{ref} - Q_{fb}) is input so as to correspond to the values "0" to "4" of the flag FG. The ramp rate limiter 366 is connected in series to the gain application unit 364, limits the ramp rate of the input signal to a limit value Q_Ramp or less, and outputs the result as a q-axis current command value I_{qref.}

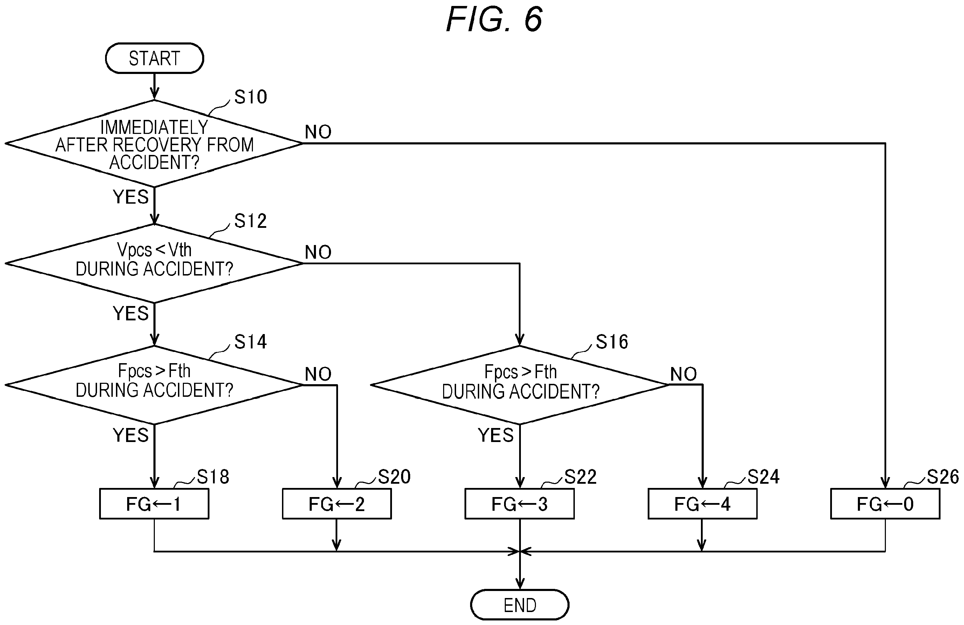

Fig. 6 is a flowchart illustrating an example of a calculation processing routine executed by the control logic change unit 320. This routine is executed, for example, for each predetermined time.

In Fig. 6, when the processing proceeds to step S10, it is determined whether or not a current state is a state of "immediately after recovery from the accident". Specifically, it is determined whether or not the current state is a state of a "predetermined specified time has not elapsed after the logic signal LG (see Fig. 5) changes from "0" to "1"". Accordingly, when the logic signal LG is "0" or when the logic signal LG is "1" for the specified time or more, the determination result is "No" in this step.

When the determination result is "No" in step S10, the processing proceeds to step S26. Here, the control logic change unit 320 sets the flag FG to "0". Accordingly, in the normal condition (when the logic signal LG is "1"), the output signals of the in-normal P command creation unit 312 and the in-normal Q command creation unit 352 (see Fig. 5) are applied as the active power command value P_{ref} and the reactive power command value Q_{ref}, respectively. In the accident condition (when the logic signal LG is "0"), the output signals of the in-accident P command creation unit 314 and the in-accident Q command creation unit 354 are applied as the active power command value P_{ref} and the reactive power command value Q_{ref}, respectively.

On the other hand, when the determination result is "Yes" in step S10, the processing proceeds to step S12. Here, it is determined whether or not there is a timing at which the interconnection point voltage Vpcs is less than the voltage threshold Vth during the accident (in a period in which the logic signal LG is "0"). When the determination result is "Yes" in step S12, the processing proceeds to step S14, and it is determined whether or not there is a timing at which the interconnection point frequency Fpcs is the frequency threshold Fth during the accident.

When the determination result is "Yes" in step S14, the processing proceeds to step S18, and the control logic change unit 320 sets the flag FG to "1". On the other hand, when the determination result is "No" in step S14, the processing proceeds to step S20, and the control logic change unit 320 sets the flag FG to "2".

When the determination result is "No" in step S12 (Vpcs ≥ Vth is constantly satisfied in the accident condition), the processing proceeds to step S16, and it is determined whether or not there is a timing at which the interconnection point frequency Fpcs is the frequency threshold Fth during the accident.

When the determination result is "Yes" in step S16, the processing proceeds to step S22, and the control logic change unit 320 sets the flag FG to "3". On the other hand, when the determination result is "No" in step S16, the processing proceeds to step S24, and the control logic change unit 320 sets the flag FG to "4". When any of steps S18 to S26 is executed, this routine ends.

The values "1" to "4" of the flag FG correspond to the above-described control methods C1 to C4, respectively. Accordingly, for example, when the flag FG is "1", the PCS behavior calculation model 300 (see Fig. 5) applies the control method C1, suppresses the active power of the renewable energy power generation, and outputs the calculation result that outputs a capacitive reactive power. That is, the PCS behavior calculation model 300 outputs the simulation results of the d-axis current command value I_{dref} and the q-axis current command value I_{qref} such that a power factor is less than a predetermined value thpf1 (not illustrated).

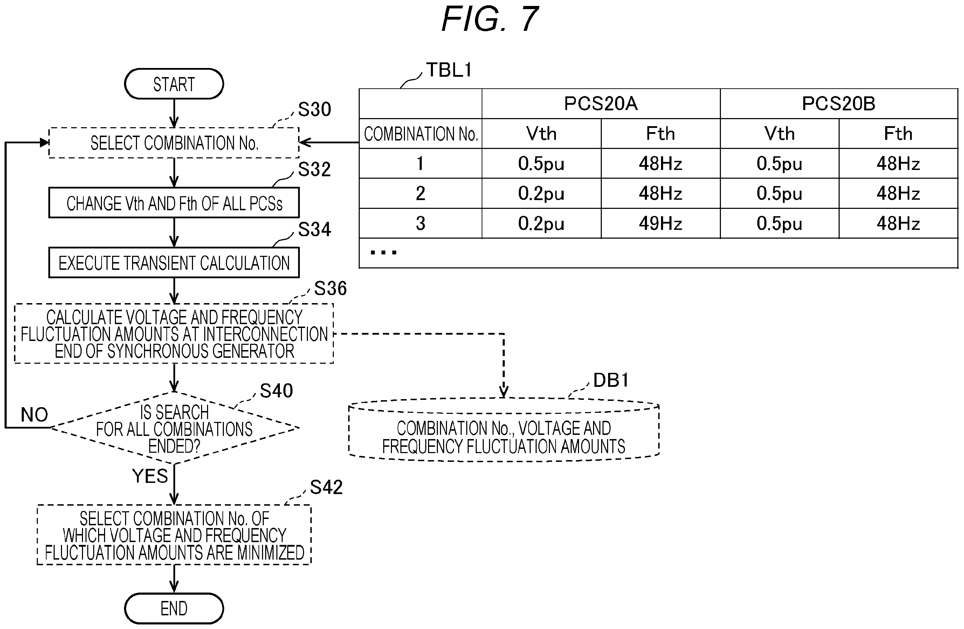

Fig. 7 is a flowchart illustrating an example of a threshold selection routine executed by the transient calculation unit 250 and the threshold candidate selection unit 266.

A table TBL1 represented in this figure is a table that stores various combinations as the threshold candidates for the voltage threshold Vth and the frequency threshold Fth for the PCS 20A (see Fig. 1) and the voltage threshold Vth and the frequency threshold Fth for the PCS 20B. Each of these combination candidates is assigned each unique "combination No.".

These combination candidates may be, for example, input by a manual operation of a user, or may be randomly decided by a computer by narrowing a range of each threshold. In Fig. 7, blocks indicated by a broken line represent processing executed by the threshold candidate selection unit 266, and blocks indicated by a solid line represent processing executed by the transient calculation unit 250.

When the processing proceeds to step S30 in Fig. 7, the threshold candidate selection unit 266 selects one combination No. that is not selected yet from the table TBL1. Subsequently, when the processing proceeds to step S32, the transient calculation unit 250 sets a state of the PCS behavior calculation model 300 (see Fig. 4) according to the selected combination No.. That is, the voltage threshold Vth and the frequency threshold Fth of the selected combination No. are set for the models of all the PCSs (the models of the PCSs 20A and 20B in the example of Fig. 1) belonging to the PCS behavior calculation model 300.

Subsequently, when the processing proceeds to step S34, the transient calculation unit 250 executes transient calculation. That is, the voltages, the frequencies, and the like of the electrical grid 40 in the system accident condition and after the accident removal are calculated. Subsequently, when the processing proceeds to step S36, the threshold candidate selection unit 266 acquires a voltage fluctuation amount and a frequency fluctuation amount at the cooperation point 78 (see Fig. 1) to which the synchronous generator 70 is connected from the synchronous generator behavior calculation model 251 (see Fig. 4). The reason why the voltage fluctuation amount and the like at the cooperation point 78 are acquired is that it is considered that a state of the cooperation point 78 to which the synchronous generator 70 is connected has the largest influence on the stable operation of the entire electrical grid 40.

The threshold candidate selection unit 266 stores the calculation result in step S36, that is, the voltage fluctuation amount and the frequency fluctuation amount together with the combination No. in a database DB1. Subsequently, when the processing proceeds to step S40, the threshold candidate selection unit 266 determines whether or not the search is ended for all the combinations stored in the table TBL1, that is, whether or not the voltage fluctuation amount and the frequency fluctuation amount are calculated. Here, when the determination result is "No", the processing returns to step S30. That is, any combination that is not selected yet is selected, and the tasks of processing of steps S32 to S36 described above are executed.

When the determination result is "Yes" in step S40, the processing proceeds to step S42. Here, the threshold candidate selection unit 266 selects one combination No. based on the voltage fluctuation amount and the frequency fluctuation amount of each combination No.. For example, a combination No. having a minimum voltage fluctuation amount may be selected, or a combination No. having a minimum frequency fluctuation amount may be selected. Thus, the tasks of processing of this routine are ended.

After the tasks of processing of this routine are ended, the threshold candidate selection unit 266 (see Fig. 2) transmits the voltage threshold Vth and the frequency threshold Fth in the selected combination No. to the PCSs 20A and 20B (see Fig. 1) via the threshold transmission unit 268. In each of the PCS 20A and 20B, the threshold reception unit 270 (see Fig. 2) supplies the received voltage threshold Vth and frequency threshold Fth to the PCS control unit 280.

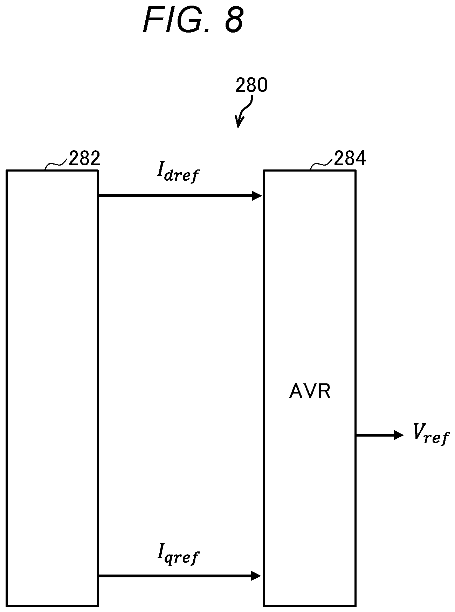

Fig. 8 is a block diagram illustrating an example of a control block of the PCS control unit 280.

As illustrated in Fig. 8, the PCS control unit 280 includes a current command value output unit 282 and an automatic voltage regulator (AVR) 284. Here, a configuration of the current command value output unit 282 is similar to that of the PCS behavior calculation model 300 illustrated in Fig. 5. Accordingly, similarly to the PCS behavior calculation model 300, the current command value output unit 282 outputs the d-axis current command value I_{dref} and the q-axis current command value I_{qref.} However, in the current command value output unit 282, the voltage threshold Vth and the frequency threshold Fth transmitted from the threshold transmission unit 268 (see Fig. 2) to the threshold reception unit 270 are applied.

The AVR 284 outputs a voltage command value V_{ref} based on the d-axis current command value I_{dref} and the q-axis current command value I_{qref.} The voltage command value V_{ref} is supplied to the switch operation decision unit 272 (see Fig. 2), and the switch operation decision unit 272 decides the switching methods of the corresponding DC/AC converters 24A and 24B based on the voltage command value V_{ref}.

### Second embodiment

Next, a renewable energy power generation system according to a preferred second embodiment will be described. In the following description, units corresponding to the units of the above-described first embodiment are denoted by the same reference numerals, and the description thereof may be omitted. First, the entire configuration of the present embodiment is similar to that of the first embodiment (Fig. 1).

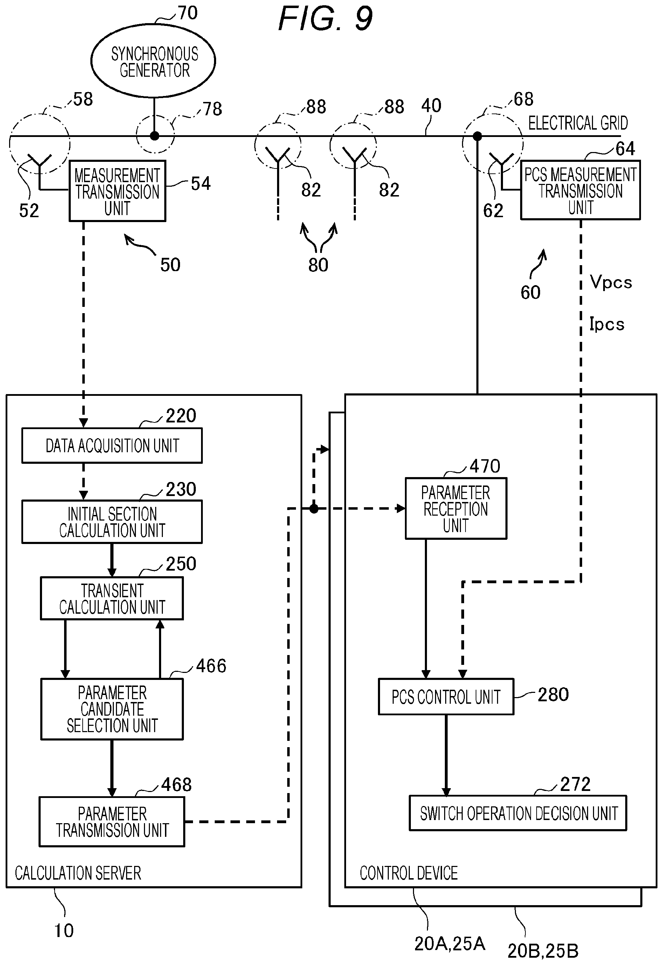

Fig. 9 is a functional block diagram illustrating functions and the like realized by the calculation server 10 and the control devices 25A and 25B of the PCSs 20A and 20B in the present embodiment.

In Fig. 9, a parameter candidate selection unit 466 (candidate selection unit), a parameter transmission unit 468, and a parameter reception unit 470 are provided instead of the threshold candidate selection unit 266, the threshold transmission unit 268, and the threshold reception unit 270 in the above-described first embodiment (see Fig. 2).

In the above-described first embodiment, the calculation server 10 transmits the voltage threshold Vth and the voltage threshold Vth to the control devices 25A and 25B. Instead, the present embodiment is different in that the calculation server 10 transmits various parameters to the control devices 25A and 25B. The parameters transmitted from the calculation server 10 to the control devices 25A and 25B are, for example, the gains APR0 to APR4, the limit values P_Ramp0 to P_Ramp4, the reactive power command values Q_{ref1} to Q_{ref4}, the gain AQR, the limit value Q_Ramp, and the like illustrated in Fig. 5.

Hereinafter, a method of deciding the reactive power command values Q_{ref1} to Q_{ref4} in the calculation server 10 will be described as an example.

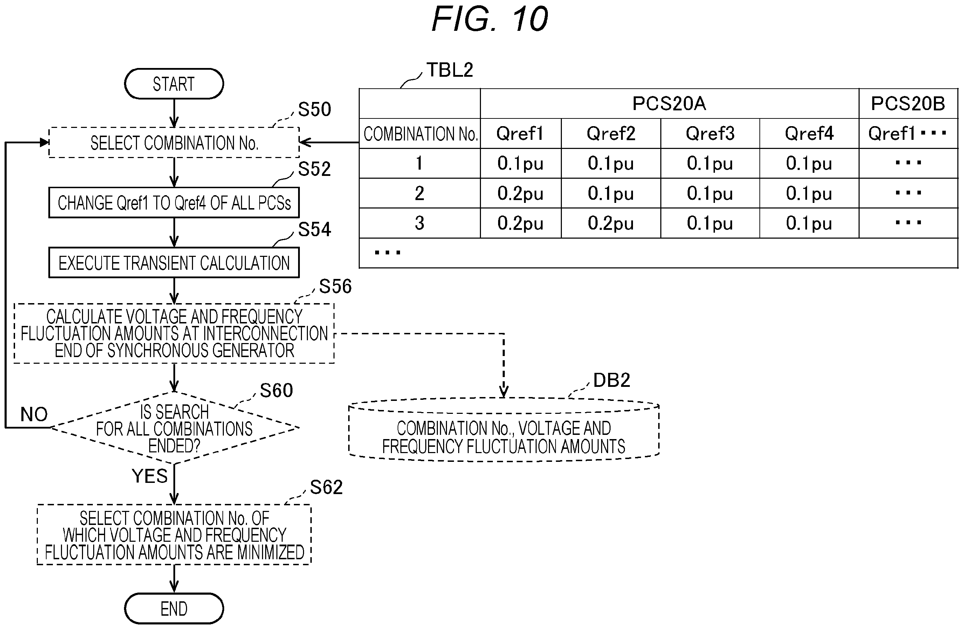

Fig. 10 is a flowchart illustrating an example of a reactive power command value selection routine executed by the transient calculation unit 250 and the parameter candidate selection unit 466 according to the present embodiment. In the present embodiment, the calculation server 10 executes a plurality of routines for selecting the above-described various parameters instead of the threshold selection routine (Fig. 7) in the first embodiment. An example of the plurality of routines is the reactive power command value selection routine illustrated in Fig. 10.

A table TBL2 represented in Fig. 10 is a table that stores combinations of the reactive power command values Q_{ref1} to Q_{ref4} for the PCSs 20A and 20B (see Fig. 1). Each of these combination candidates is assigned each unique "combination No.". These combination candidates may be, for example, input by a manual operation of a user, or may be randomly decided by a computer by narrowing a range of each threshold. In Fig. 10, blocks indicated by a broken line represent processing executed by the parameter candidate selection unit 466, and blocks indicated by a solid line represent processing executed by the transient calculation unit 250.

When the processing proceeds to step S50 in Fig. 10, the parameter candidate selection unit 466 selects one combination No. that is not selected yet from the table TBL2. Subsequently, when the processing proceeds to step S52, the transient calculation unit 250 sets the state of the PCS behavior calculation model 300 (see Fig. 4) according to the selected combination No.. That is, the reactive power command values Q_{ref1} to Q_{ref4} of the selected combination No. are set to the models of all the PCSs (the models of the PCSs 20A and 20B in the example of Fig. 1) belonging to the PCS behavior calculation model 300.

Subsequently, when the processing proceeds to step S54, the transient calculation unit 250 executes transient calculation. That is, the voltages, the frequencies, and the like of the electrical grid 40 in the system accident condition and after the accident removal are calculated. Subsequently, when the processing proceeds to step S56, the parameter candidate selection unit 466 acquires the voltage fluctuation amount and the frequency fluctuation amount at the cooperation point 78 (see Fig. 1) to which the synchronous generator 70 is connected from the synchronous generator behavior calculation model 251 (see Fig. 4).

The parameter candidate selection unit 466 stores the calculation result in step S56, that is, the voltage fluctuation amount and the frequency fluctuation amount together with the combination No. in a database DB2. Subsequently, when the processing proceeds to step S60, the parameter candidate selection unit 466 determines whether or not the search is ended for all the combinations stored in the table TBL2, that is, whether or not the voltage fluctuation amount and the frequency fluctuation amount are calculated. Here, when the determination result is "No", the processing returns to step S50. That is, any combination that is not selected yet is selected, and the tasks of processing of steps S52 to S56 described above are executed.

When the determination result is "Yes" in step S60, the processing proceeds to step S62. Here, the parameter candidate selection unit 466 selects one combination No. based on the voltage fluctuation amount and the frequency fluctuation amount of each combination No.. For example, a combination No. having a minimum voltage fluctuation amount may be selected, or a combination No. having a minimum frequency fluctuation amount may be selected. Thus, the tasks of processing of this routine are ended.

After the tasks of processing of this routine are ended, the parameter candidate selection unit 466 (see Fig. 9) transmits the reactive power command values Q_{ref1} to Q_{ref4} for the selected combination No. to the control devices 25A and 25B (see Fig. 9) of the PCSs via the parameter transmission unit 468. In each of the control devices 25A and 25B, the parameter reception unit 470 (see Fig. 9) supplies the received reactive power command values Q_{ref1} to Q_{ref4} to the PCS control unit 280. Although the method of setting the reactive power command values Q_{ref1} to Q_{ref4} in the control devices 25A and 25B has been described above, the calculation server 10 similarly sets other parameters in the control devices 25A and 25B.

### Third embodiment

Next, a renewable energy power generation system according to a preferred third embodiment will be described. In the following description, units corresponding to the units of the above-described first embodiment are denoted by the same reference numerals, and the description thereof may be omitted. First, the entire configuration of the present embodiment is similar to those of the first and second embodiments (Fig. 1).

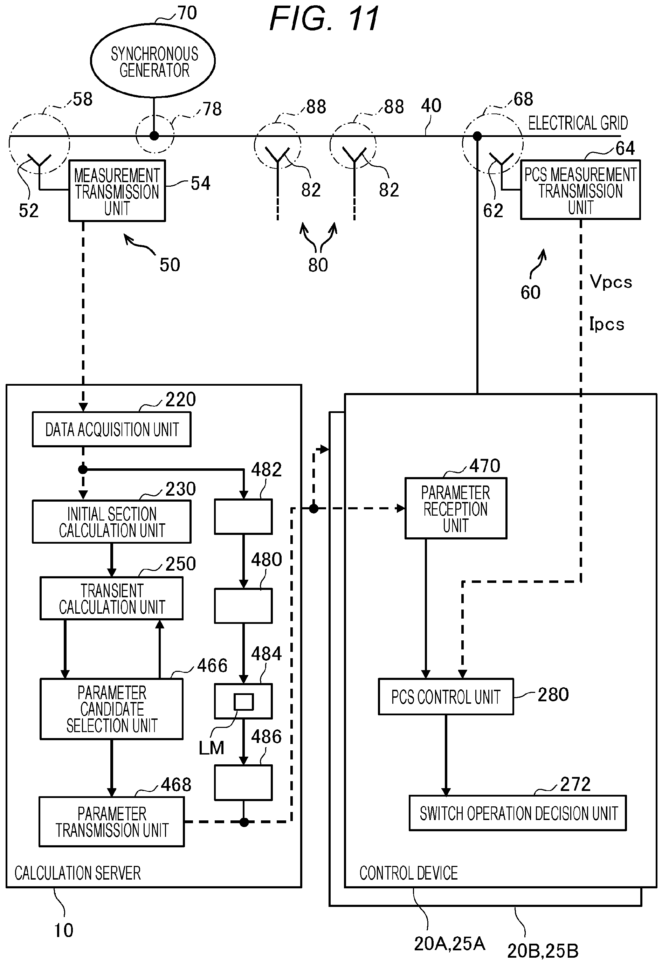

Fig. 11 is a functional block diagram illustrating functions and the like realized by the calculation server 10 and the control devices 25A and 25B of the PCSs 20A and 20B in the present embodiment. The present embodiment includes a teaching data storage device 480 (storage device), an accumulation control unit 482, a learning model generation unit 484, and a parameter decision unit 486 in addition to the configuration of the above-described second embodiment (see Fig. 9).

The accumulation control unit 482 accumulates, as teaching data, the measurement data acquired from the measurement units 50, 60, 80, and the like and the data acquired from the PCSs 20A and 20B in the teaching data storage device 480. The learning model generation unit 484 generates a learning model LM having the measurement data acquired by the data acquisition unit 220 as input data, and the various parameters in the PCS behavior calculation model 300 (see Fig. 5) as output data based on the teaching data.

That is, the above-described "various parameters" are the voltage threshold Vth, the frequency threshold Fth, the gains APR0 to APR4, the limit values P_Ramp0 to P_Ramp4, the reactive power command values Q_{ref1} to Q_{ref4}, the gain AQR, the limit value Q_Ramp, or the like. The parameter decision unit 486 generates the above-described various parameters based on the measurement data acquired by the data acquisition unit 220 and the learning model LM.

In the above-described first and second embodiments, the values of the parameters to be set in the control devices 25A and 25B are decided in a round-robin manner. However, when the calculation result by the transient calculation unit 250 is accumulated, the above-described various parameters can be decided based on a demand distribution in the electrical grid 40, power generation outputs of the PCSs 20A and 20B, an output of the synchronous generator 70, and the like by performing pattern recognition by machine learning or the like without performing round-robin calculation.

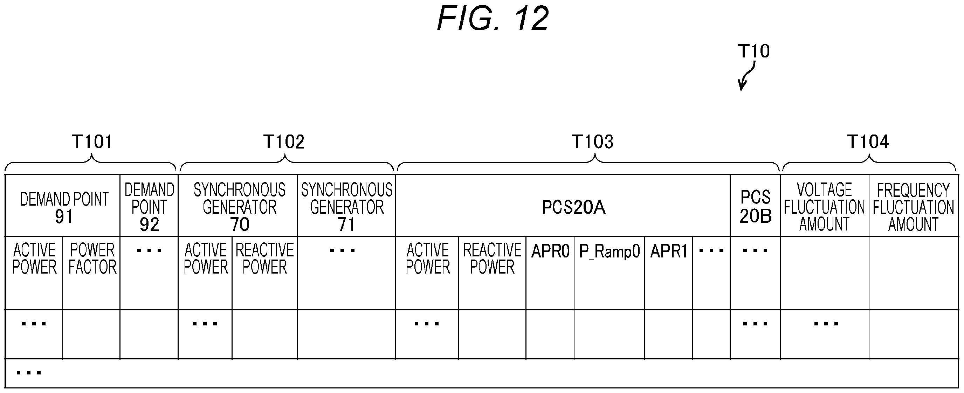

Fig. 12 is a diagram illustrating an example of types of teaching data used for machine learning.

In Fig. 12, teaching data T10 includes data groups T101, T102, T103, and T104.

Here, the data group T101 indicates active power consumptions and power factors at the demand points 91 and 92 and the like (see Fig. 1) in the system in the normal condition.

The data group T102 includes active powers and reactive powers output from the synchronous generators 70 and 71 and the like to the electrical grid 40 in the normal condition.

The data group T103 includes the active and reactive powers, the gains APR0 to APR4, the limit values P_Ramp0 to P_Ramp4, the reactive power command values Q_{ref0} to Q_{ref4}, and the like supplied from the PCSs 20A and 20B to the electrical grid 40 in the normal condition.

The data group T104 includes the voltage fluctuation amount and the frequency fluctuation amount at the measurement point 68 after the accident removal.

The data groups T101, T102, and T103 represent states of the electrical grid 40 before the occurrence of the accident. Since these data groups influence the voltage fluctuation and the frequency fluctuation of the electrical grid 40 in the accident condition and after the accident removal, these data groups are included in the teaching data T10. The teaching data T10 can be accumulated by combining the calculation results of the transient calculation unit 250 and calculation conditions.

### Effects of embodiment

According to the preferred embodiment as described above, the electrical grid control device (10, 25A, 25B) includes the data acquisition unit (220) that acquires the measurement data including the voltage value and the current value of each unit in the electrical grid (40) to which the power conversion device (20A, 20B) is connected, and the control method selection unit (268, 320) that selects the control methods (C1 to C4) when the active power (P_{fb}) and the reactive power (Q_{fb}) output to the electrical grid (40) by the power conversion device (20A, 20B) are controlled based on the acquired measurement data. Accordingly, the electrical grid (40) can be appropriately stabilized by selecting an appropriate control method (C1 to C4).

It is more preferable that the control method selection unit (268, 320) includes the threshold generation unit (268) that outputs the voltage threshold (Vth) and the frequency threshold (Fth), and the control method change unit (320) that selects the control method (C1 to C4) based on a comparison result between the interconnection point voltage (Vpcs) and the interconnection point frequency (Fpcs) at the predetermined interconnection point (68) of the electrical grid (40) with the voltage threshold (Vth) and the frequency threshold (Fth). Accordingly, the appropriate control methods (C1 to C4) can be selected based on the state of the interconnection point (68).

It is more preferable that the control method selection unit (268,320) has a function of switching between the gains (APR1 to APR4) related to the active power (P_{fb}) based on the selected control methods (C1 to C4). Accordingly, the appropriate gains (APR1 to APR4) related to the active power (P_{fb}) can be selected according to the control methods (C1 to C4).

It is more preferable that the control method selection unit (268,320) has a function of switching between the ramp rate limit values (P_Ramp0 to P_Ramp4) related to the active power (P_{fb}) based on the selected control methods (C1 to C4). Accordingly, the appropriate ramp limit value (P_Ramp0 to P_Ramp4) related to the active power (P_{fb}) can be selected according to the control methods (C1 to C4).

It is more preferable that the control method selection unit (268, 320) has a function of switching between the reactive power command values (Q_{ref1} to Q_{ref4}) for commanding the reactive power (Q_{fb}) based on the selected control methods (C1 to C4). Accordingly, the appropriate reactive power command values (Q_{ref1} to Q_{ref4}) cab be selected according to the control methods (C1 to C4).

It is more preferable that the electrical grid control device (10, 25A, 25B) further includes the transient calculation unit (250) that calculates the fluctuations in the voltage and frequency in the electrical grid (40) when the accident occurs in the electrical grid (40) and the candidate selection unit (266, 466) that acquires the calculation result in the transient calculation unit (250) while changing the candidates for the parameters (Vth, Fth, Q_{ref0} to Q_{ref4}, and the like) given to the transient calculation unit (250) and selects any candidate as the parameter (Vth, Fth, Q_{ref0} to Q_{ref4}, and the like) based on the acquired calculation result. Accordingly, the preferable candidate can be selected as the parameter (Vth, Fth, Q_{ref0} to Q_{ref4}, and the like) from among the plurality of candidates based on the calculation result in the transient calculation unit (250).

It is more preferable that after the transient calculation unit (250) outputs the calculation result, the electrical grid control device (10, 25A, 25B) further includes the accumulation control unit (482) that accumulates the active power consumptions and the power factors at the demand point (91, 92) to which the load is connected in the electrical grid (40), the active power (P_{fb}) and the reactive power (Q_{fb}) output from the power conversion device (20A, 20B), the gains (APR1 to APR4) and the ramp rate limit values (P_Ramp0 to P_Ramp4) related to the active power (P_{fb}), the reactive power command values (Q_{ref1} to Q_{ref4}) for commanding the reactive power (Q_{fb}), the voltage fluctuation amount of the interconnection point voltage (Vpcs) and the frequency fluctuation amount of the interconnection point frequency (Fpcs) at the predetermined interconnection point (68) of the electrical grid (40) after the accident removal in the storage device (480), the learning model generation unit (484) that generates the learning model (LM) having the data accumulated in the storage device (480) as the teaching data, the measurement data as the input data, and the parameter (Vth, Fth, Q_{ref0} to Q_{ref4}, and the like) as the output, and the parameter decision unit (486) that outputs the parameters (Vth, Fth, Q_{ref0} to Q_{ref4}, and the like) based on the learning model (LM) and the measurement data. Accordingly, the parameters (Vth, Fth, Q_{ref0} to Q_{ref4}, and the like) can be output based on the learning model (LM).

It is more preferable that the control method selection unit (268, 320) has a function of selecting the control method (C1 to C4) to be applied from among the first control method (C1) for outputting the capacitive reactive power to the electrical grid (40) by means of the power conversion device (20A, and 20B) and setting the power factor of the power conversion device (20A, 20B) to be less than the predetermined first power factor (thpf1), the second control method (C2) for outputting the capacitive reactive power to the electrical grid (40) and setting the power factor of the power conversion device (20A, 20B) to be equal to or greater than the first power factor (thpf1) by means of the power conversion device (20A, 20B), the third control method (C3) for outputting the inductive reactive power to the electrical grid (40) and setting the power factor of the power conversion device (20A, 20B) to be less than the predetermined second power factor (thpf2) by means of the power conversion device (20A, 20B), and the fourth control method (C4) for outputting the inductive reactive power to the electrical grid (40) and setting the power factor of the power conversion device (20A, 20B) to be equal to or greater than the second power factor (thpf2) by means of the power conversion device (20A, 20B). Accordingly, it is possible to appropriately decide which of the capacitive reactive power and the inductive reactive power is to be generated and what range the power factor is to be set according to the control methods (C1 to C4).

### Modification example

The present invention is not limited to the above-described embodiments, and various modifications are possible. The aforementioned embodiments are described in detail in order to facilitate easy understanding of the present invention, and are not limited to necessarily include all the described components. Some of the components of a certain embodiment can be substituted into the components of other embodiments, and the components of other embodiments can be added to the component of a certain embodiment. Other components can be removed, added, and substituted from, to, and into some of the components of each of the aforementioned embodiments. Control lines and information lines represented in the drawings illustrate lines which are considered to be necessary for the description, and not all the control lines and information lines in a product are necessarily illustrated. Almost all the configurations may be considered to be actually connected to each other. Modifications possible for the above-described embodiments are, for example, as follows.
(1) In steps S40 and S42 (see Fig. 7) in the first embodiment and steps S60 and S62 (see Fig. 10) in the second embodiment, one combination No. to be transmitted to the control devices 25A and 25B is selected under the condition that the search is ended for all the combinations stored in the table TBL1 or TBL2. However, in selecting one combination No., it is not always necessary to perform the search for all the combinations. That is, when the voltage fluctuation amount and the frequency fluctuation amount are sufficiently small for a certain combination No. (for example, when the voltage fluctuation amount is equal to or less than the predetermined voltage fluctuation amount threshold and the frequency fluctuation amount is equal to or less than the predetermined frequency fluctuation amount), the parameters of the combination No. may be transmitted to the threshold reception units 270 of the control devices 25A and 25B.
(2) In each of the above-described embodiments, the power generation power sources 30A and 30B are not necessarily required to be the renewable energy power generation power sources. That is, as long as the power sources can control the active powers and the reactive powers supplied to the electrical grid 40 through the PCSs 20A and 20B, various power sources can be applied as the power generation power sources 30A and 30B.
(3) Since the hardware of the calculation server 10 and the control devices 25A and 25B in the above-described embodiment can be realized by the general computer, the flowcharts illustrated in Figs. 6, 7, and 10, the program for executing the various kinds of processing described above, and the like may be stored in a storage medium or may be distributed via a transmission path.
(4) The tasks of processing illustrated in Figs. 6, 7, and 10 and other tasks of processing described above have been described as software processing using the program in the above-described embodiment, but some or all of the tasks of processing may be replaced with hardware processing using an application specific integrated circuit (ASIC; application specific IC), a field programmable gate array (FPGA), or the like. The teaching data storage device 480 illustrated in Fig. 11 may be provided in a cloud on a network (not illustrated).

## Claims

1. An electrical grid control device comprising:
a data acquisition unit that acquires measurement data including a voltage value and a current value of each unit in an electrical grid to which a power conversion device is connected; and
a control method selection unit that selects a control method when active power and reactive power output to the electrical grid by the power conversion device are controlled based on the acquired measurement data.

2. The electrical grid control device according to claim 1, wherein
the control method selection unit includes
a threshold generation unit that outputs a voltage threshold and a frequency threshold, and
a control method change unit that selects the control method based on a comparison result of an interconnection point voltage and an interconnection point frequency at a predetermined interconnection point of the electrical grid with the voltage threshold and the frequency threshold.

3. The electrical grid control device according to claim 1, wherein
the control method selection unit has a function of switching between gains related to the active power based on the selected control method.

4. The electrical grid control device according to claim 1, wherein
the control method selection unit has a function of switching between ramp rate limit values related to the active power based on the selected control method.

5. The electrical grid control device according to claim 1, wherein
the control method selection unit has a function of switching between reactive power command values for commanding the reactive power based on the selected control method.

6. The electrical grid control device according to claim 1, further comprising:
a transient calculation unit that calculates fluctuations in a voltage and a frequency in the electrical grid when an accident occurs in the electrical grid; and
a candidate selection unit that acquires a calculation result in the transient calculation unit while changing candidates for a parameter given to the transient calculation unit, and selects, as the parameter, any of the candidates based on the acquired calculation result.

7. The electrical grid control device according to claim 6, further comprising:
an accumulation control unit that accumulates, in a storage device, an active power consumption and a power factor at a demand point which is a point to which a load is connected in the electrical grid, the active power and the reactive power output by the power conversion device, a gain and a ramp rate limit value related to the active power, a reactive power command value for commanding the reactive power, and a voltage fluctuation amount of an interconnection point voltage and a frequency fluctuation amount of an interconnection point frequency at a predetermined interconnection point of the electrical grid after accident removal after the transient calculation unit outputs the calculation result;
a learning model generation unit that generates a learning model having data accumulated in the storage device as teaching data, the measurement data as input data, and the parameter as an output; and
a parameter decision unit that outputs the parameter based on the learning model and the measurement data.

8. The electrical grid control device according to claim 1, wherein
the control method selection unit has a function of selecting the control method to be applied from among a first control method for outputting a capacitive reactive power to the electrical grid by the power conversion device and setting a power factor of the power conversion device to be less than a predetermined first power factor, a second control method for outputting the capacitive reactive power to the electrical grid by the power conversion device and setting the power factor of the power conversion device to be equal to or greater than the first power factor, a third control method for outputting an inductive reactive power to the electrical grid by the power conversion device and setting the power factor of the power conversion device to be less than a predetermined second power factor, and a fourth control method for outputting the inductive reactive power to the electrical grid by the power conversion device and setting the power factor of the power conversion device to be equal to or greater than the second power factor.

9. A power generation system comprising:
a power generation power source;
a power conversion device that is inserted between the power generation power source and an electrical grid;
a data acquisition unit that acquires measurement data including a voltage value and a current value of each unit in the electrical grid; and
a control method selection unit selects a control method when active power and reactive power output to the electrical grid by the power conversion device are controlled based on the acquired measurement data.
